Europäisches Patentamt

European Patent Office

Office européen des brevets

(11) Veröffentlichungsnummer: **0 386 841**
**A2**

(12) **EUROPÄISCHE PATENTANMELDUNG**

(21) Anmeldenummer: **90200505.7**

(22) Anmeldetag: **05.03.90**

(51) Int. Cl.5: **G11C 7/00**

(30) Priorität: **10.03.89 DE 3907722**

(43) Veröffentlichungstag der Anmeldung:
**12.09.90 Patentblatt 90/37**

(84) Benannte Vertragsstaaten:
**DE FR GB IT**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB IT**

(72) Erfinder: **Grigat, Rolf-Rainer, Dr.**
**Wendlohstrasse 91**
**D-2000 Hamburg 61(DE)**

(74) Vertreter: **Poddig, Dieter, Dipl.-Ing. et al**
**Philips Patentverwaltung GmbH**
**Wendenstrasse 35 Postfach 10 51 49**
**D-2000 Hamburg 1(DE)**

(54) **Speicheranordnung.**

(57) Es wird eine Speicheranordnung (14) beschrieben zum Abspeichern der Bildpunktdaten eines Fernsehbildes

- mit einem block- und darin spalten- und zeilenweise gegliederten Hauptspeicher (1),
- einem Spaltendecoder (12001, ...) zu jedem Hauptspeicherblock (11001, ...) zum Auswählen einer Spalte des Hauptspeichers (1) gemäß einer von außerhalb zuführbaren Spaltenadresse (an 81),
- einem für alle Hauptspeicherblöcke (11001, ...) wirksamen Zeilendecoder (90) zum gemeinsamen Auswählen einer Zeile in jeder Spalte jedes Hauptspeicherblocks (11001, ...) gemäß einer von außerhalb zuführbaren Zeilenadresse (an 87),

- wenigstens einer Eingabeanordnung (2) aus einem Eingangsschieberegister (21) zum bildpunktseriellen Einlesen abzuspeichernder Bildpunktdaten (an 20) und einem Schreibspeicher (24) zur bildparallelen Übergabe der Bildpunktdaten vom Eingangsschieberegister (21) zu je Datenbit einem der Hauptspeicherblöcke (11001, ...)
- und wenigstens zwei Ausgabeanordnungen (4, 5) aus je einem Ausgangsschieberegister (43, 53) zum bildpunktseriellen Auslesen auszugebender Bildpunktdaten (an 44, 54) und einem Lesespeicher (40, 50) zur bitparallelen Übergabe der Bildpunktdaten von je Datenbit einem der Hauptspeicherblöcke (11001, ...) zum Ausgangsschieberegister (43, 53).

Fig.1

## Speicheranordnung

Die Erfindung bezieht sich auf eine Speicheranordnung zum Abspeichern der Bildpunktdaten eines Fernsehbildes.

Es ist ein Bildspeicherbaustein der Typenbezeichnung TC 521000P (Hersteller: Toshiba) vorgeschlagen worden, der einen Speicherbereich aus dynamischen Speicherzellen umfaßt, die in Zellen, Spalten und Zeilen organisiert sind. Mit insgesamt 15 Adreßbits werden in Adreßspeichern und -decodern innerhalb jeder der Scheiben die Spalten und innerhalb der Spalten die Zeilen adressiert und ausgewählt. Zur Dateneingabe dient ein Eingangsschieberegister, in welches die zu speichernden Daten seriell eingelesen werden. Über einen Schreib-Zwischenspeicher und einen Eingabe-/Ausgabe-Schalter je Scheibe werden die Daten in den Speicherbereich übertragen. Zum Auslesen der Daten gelangen diese über den Eingabe-/Ausgabe-Schalter und einen Lese-Zwischenspeicher je Scheibe parallel auf ein Ausgangs-Schieberegister, aus dem sie seriell ausgelesen werden.

Für einen Einsatz als Bildspeicher in Fernsehempfängern muß eine Speicheranordnung verschiedene Anwendungen und Betriebsweisen ermöglichen. Dazu gehören insbesondere der Einsatz für eine flimmerfreie Darstellung, insbesondere eine von Zeilenflimmern, Kantenflackern und Großflächenflimmern freie Bildwiedergabe. Die Speicheranordnung muß außerdem für den Einsatz in einer rekursiven Filterung geeignet sein. Außerdem müssen Bildausschnitte und -vergrößerungen sowie Bild-Im-Bild-Darstellungen bewerkstelligt werden.

Die Erfindung hat die Aufgabe, eine Speicheranordnung zu schaffen, die einen universellen Einsatz in Fernsehempfängern gemäß den vorstehenden Kriterien ermöglicht und die dabei einfach aufgebaut ist.

Erfindungsgemäß ist zur Lösung dieser Aufgabe eine Speicheranordnung zum Abspeichern der Bildpunktdaten eines Fernsehbildes versehen mit einem block- und darin spalten-und zeilenweise gegliederten Hauptspeicher, einem Spaltendecoder zu jedem Hauptspeicherblock zum Auswählen einer Spalte des Hauptspeichers gemäß einer von außerhalb zuführbaren Spaltenadresse, einem für alle Hauptspeicherblöcke wirksamen Zeilendecoder zum gemeinsamen Auswählen einer Zeile in jeder Spalte jedes Hauptspeicherblocks gemäß einer von außerhalb zuführbaren Zeilenadresse, wenigstens einer Eingabeanordnung aus einem Eingangsschieberegister zum bildpunktseriellen Einlesen abzuspeichernder Bildpunktdaten und einem Schreibspeicher zur bitparallelen Übergabe der Bildpunktdaten vom Eingangsschieberegister zu je Datenbit einem der Hauptspeicherblöcke und wenigstens zwei Ausgabeanordnungen aus je einem Ausgangsschieberegister zum bildpunktseriellen Auslesen auszugebender Bildpunktdaten und einem Lesespeicher zur bitparallelen Übergabe der Bildpunktdaten von je Datenbit einem der Hauptspeicherblöcke zum Ausgangsschieberegister.

Die Bildpunktdaten eines Fernsehbildes bestehen üblicherweise aus je einem mehrere Datenbits umfassenden Datenwort je Bildpunkt. Diese Datenworte werden in der Regel bitparallel und bildpunktseriell übertragen, d.h. die Datenbits zu jedem Datenwort parallel und die einzelnen Datenworte seriell. Davon ausgehend weist der Hauptspeicher der erfindungsgemäßen Speicheranordnung eine Block-, Zeilen- und Spaltengliederung auf, die sich möglichst eng an die Zeilen- und Spaltengliederung des Fernsehbildes anlehnt. Dadurch ist es möglich, das Datenwort zu jedem beliebigen Bildpunkt in einfacher Weise mit der Adressierung aus dem Fernsehbild aus dem Speicher auszulesen bzw. darin einzuschreiben.

Zwischen dem Einlesen abzuspeichernder Bildpunktdaten oder dem bildpunktseriellen Auslesen auszugebender Bildpunktdaten und der Übergabe in den bzw. aus dem Hauptspeicher findet einerseits eine Formatwandlung der übertragenen Daten und damit eine Wandlung der Übertragungsgeschwindigkeit und andererseits durch die Schreib- und Lesespeicher eine Entkopplung der Ein- und Ausgabeanordnungen vom Hauptspeicher statt. Dadurch können die Ein- und Ausgänge der Speicheranordnung, die mit den Ein- bzw. Ausgabeanordnungen verbunden sind, mit von der internen Datenübertragungsrate des Hauptspeichers unabhängigen Datenraten bzw. Übertragungsfrequenzen betrieben werden. Jeder der Ein- bzw. Ausgänge kann mit einer in weiten Grenzen beliebigen Übertragungsfrequenz betrieben werden. Diese Übertragungsfrequenz wird ausschließlich durch von außen der Speicheranordnung zugeführte, dem jeweiligen Ein-bzw. Ausgang zugeordnete Taktsignale vorgeben. Der modulare Aufbau der erfindungsgemäßen Speicheranordnung, d.h. die Gliederung in Hauptspeicher, Ein- und Ausgabeanordnungen ermöglicht so eine universelle Betriebsweise. Dabei ist durch die Umwandlung des Datenformats der Bildpunktdaten in den Ein- und Ausgangsschieberegistern eine Verringerung der Übertragungsfrequenz im Hauptspeicher gegenüber den Ein- und Ausgängen gegeben, wodurch hinreichende Zeitintervalle für die abwechselnde Übergabe der Bildpunktdaten zu den einzelnen Schieberegisters zur Verfügung stehen, ohne daß dadurch beispielsweise die Datenein- bzw. -ausgabe an einem der Ein-bzw. Ausgänge gestört oder unterbrochen würde.

Damit kann eine für die Verarbeitung der Bildpunktdaten eines Fernsehbildes vorgegebene, minimale Datenrate bzw. Übertragungsfrequenz gewährleistet werden.

Die erfindungsgemäße Speicheranordnung ist somit universell einsetzbar, und zwar auch für mehrere Fernsehnormen. Der modulare Aufbau und die Gliederung des Hauptspeichers ermöglichen darüber hinaus eine einfache Zusammenschaltung auch mehrerer Speicheranordnungen der erfindungsgemäßen Art, wobei dadurch wahlweise eine größere Anzahl von Bildpunkten, d.h. Datenworten oder Datenworte mit einer größeren Anzahl von Datenbits abgespeichert werden können. Der dabei nur geringe, erforderliche Schaltungsaufwand zum Ansteuern der zusammengeschalteten Speicheranordnungen ermöglicht eine breite Verwertbarkeit auch im Bereich der Konsumgüter.

Vorteilhaft ist jede der Ein- und Ausgabeanordnungen außer mit unterschiedlicher Datenfrequenz wahlweise auch in unterschiedlicher Folge der Datenein- und -ausgabe betreibbar. In einer ausschließlich durch externe Steuersignale bestimmten Datenfrequenz und Folge können also "langsame" und "schnelle" Datenein- und -ausgänge gebildet werden. Auch können mehrere Datenein- oder -ausgänge durch extern zugeschaltete Multiplexanordnungen zu Datenanschlüssen nochmals erhöhter Übertragungsfrequenz verbunden werden.

Der Hauptspeicher ist weiterhin vorteilhaft mit dynamischen Speicherzellen aufgebaut, und der Zeilendecoder ist mit einer Speicherzellen-Auffrischeinrichtung gekoppelt. Dynamische Speicherzellen, gebildet aus über Feldeffekttransistoren ein- und ausschaltbaren Kapazitäten auf einem Halbleiterkristall, verbinden den Vorteil geringen Flächenbedarfs mit dem Nachteil geringer Arbeitsgeschwindigkeiten. Außerdem müssen die sich mit der Zeit entladenen Kapazitäten innerhalb eines bestimmten Zeitintervalls stets neu "aufgefrischt" werden, da sonst die gespeicherten Ladungen und damit die gespeicherten Daten verloren gehen. Wird dieser Auffrischungsvorgang in einem bestimmten Zeitraster unabhängig von der Datenein- bzw. -ausgabe durchgeführt, kann dies zu einer Unterbrechung im Datenfluß führen, wenn sowohl von der Speicherzellen-Auffrischeinrichtung als auch vom Ein- bzw. Ausgang gleichzeitig uncoordiniert auf ein und dieselbe Speicherzelle zugegriffen wird. Daher ist im vorliegenden Fall das Ansprechen einer bestimmten Zeile in allen Blöcken des Hauptspeichers durch den Zeilendecoder mit einem Auffrischung des Speicherzelleninhalts gekoppelt. Vorzugsweise werden auch die Bildpunktdaten derart angeordnet im Hauptspeicher abgelegt, daß sowohl beim und durch das Ein- bzw. Auslesen allein schon eine möglichst gleichmäßige Auffrischung aller Speicherzellen vorgenommen wird.

Vorzugsweise sind Haupt-, Schreib- und Lesespeicher über einen gemeinsamen Datenbus miteinander verbunden. Eine derartige Verbindung ist nicht nur einfach aufgebaut, sondern begünstigt auch den modularen Aufbau der Speicheranordnung.

Bei einer größeren Anzahl von Ein- und/oder Ausgabeanordnungen kann es außerdem vorteilhaft sein, daß die Bildpunktdaten auf dem Datenbus in Multiplex übertragbar sind. Dadurch kann die in der Regel recht hohe Anzahl paralleler Leitungsverbindungen des Datenbusses reduziert werden. Die Steuerung eines derartigen Multiplexbetriebes ist jedoch sehr einfach, da in gleichen Zeitintervallen stets einander entsprechende Anschlüsse des Haupt- und aller Schreib- und Lesespeicher miteinander verbunden werden müssen. Sämtliche für den Multiplexbetrieb notwendigen Multiplex- bzw. Demultiplex-Einrichtungen können daher synchron zueinander mit demselben, von allen anderen Übertragungsgeschwindigkeiten und Taktsignalen unabhängigen Multiplextakt geschaltet werden.

Einige Ausführungsbeispiele der Erfindung sind in der Zeichnung dargestellt und werden im nachfolgenden näher beschrieben. Es zeigen

Fig. 1 eine erfindungsgemäße Speicheranordnung in blockschematischer Darstellung,

Fig. 2 eine Abwandlung der Speicheranordnung nach Fig. 1,

Fig. 3 ein weiteres, vereinfacht dargestelltes Ausführungsbeispiel und

Fig. 4 ein einfaches Beispiel für eine Anwendung einer erfindungsgemäßen Speicheranordnung.

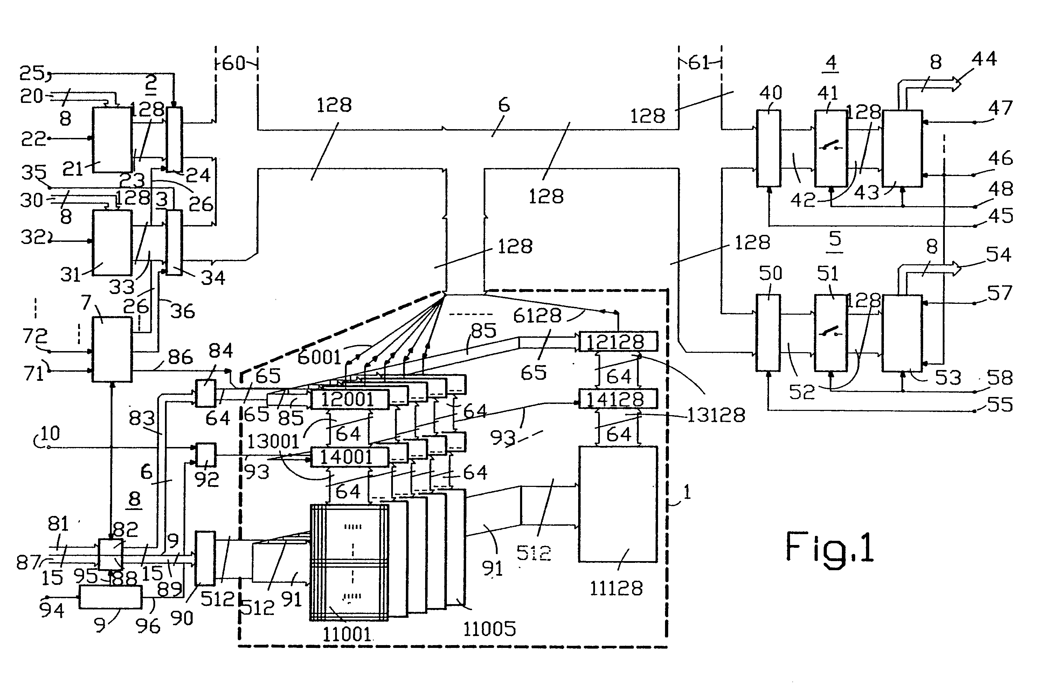

Die Speicheranordnung nach Fig. 1 ist beispielhaft mit einem Hauptspeicher 1 sowie je zwei Ein- und Ausgabeanordnungen 2, 3 bzw. 4, 5 ausgebildet. Diese Bauteile werden durch einen Datenbus 6 miteinander verbunden, der 128 parallel laufende Leitungen zur bitparallelen Übergabe der Bildpunktdaten aufweist. Ferner ist eine Schreibaktivier-Logik 7 sowie eine Adreßsteuerung 8 vorgesehen, die außerdem mit einer Speicherzellen-Auffrischeinrichtung 9 gekoppelt ist.

Der Hauptspeicher 1 umfaßt im vorliegenden Beispiel 128 Hauptspeicherblöcke 11001 bis 11128, von denen jeder eine Anzahl von dynamischen Speicherzellen umfaßt, die matrixartig in Spalten und Zeilen angeordnet sind. In Fig. 1 umfaßt jeder Hauptspeicherblock 11001 bis 11128 64 Spalten und 512 Zeilen. Diese Gliederung ist am Beispiel des Hauptspeicherblocks 11001 durch ein eingezeichnetes Gitterraster angedeutet. Die Anzahl der Spalten, Zeilen und Blöcke im Hauptspeicher wird den jeweiligen Einsatzbedingungen der Speicheranordnung angepaßt. Im beschriebenen Beispiel entspricht diese Anzahl jeweils genau einer Potenz der Zahl 2, so daß bei einer binären Adressierung der Blöcke, Spalten und Zeilen die zur Verfügung stehenden, binären Adreßkombinationen vollständig ausgenutzt werden. Für einen bestimmten Einsatzzweck der Speicheranordnung wird jedoch die Anzahl der Blöcke, Spalten und Zeilen der zu speichernden Datenmenge, d.h. insbesondere der Anzahl und dem Format der zu speichernden Bildpunktdaten in der erwünschten Fernsehnorm, angepaßt. Obgleich es dadurch Adreßkombinationen gibt, die keiner tatsächlich vorhandenen Speicherzelle zugeordnet sind, wird auch in diesem Fall eine Adressierung der Blöcke, Spalten und Zeilen mit getrennten Adreßkombinationen, d.h. getrennten Adreßbits, durchgeführt, um eine einfachere Ansteuerung der erwünschten Speicherzellen zu erreichen.

Bei der Speicheranordnung nach Fig. 1 werden abzuspeichernde Bildpunktdaten bitparallel und bildpunktseriell beispielsweise über einen Eingang 20 eines Eingangsschieberegisters 21 der Eingabeanordnung 2 zugeführt. Der Eingang 20 weist dazu entsprechend der Datenwortbreite der Bildpunktdaten acht Pole auf. Jeweils 16 aufeinanderfolgende Datenworte werden bildpunktseriell in das Eingangsschieberegister 21 eingelesen. Die Einlesegeschwindigkeit wird durch ein über einen Takteingang 22 zugeführtes Einlesetaktsignal bestimmt. Das Eingangsschieberegister 21 weist die Größe 16x8 Bit auf.

Nach vollständigem Laden des Eingangsschieberegisters 21 mit Bildpunktdaten von insgesamt 16 Bildpunkten werden alle Datenbits aus dem Eingangsschieberegister 21 über eine 128polige Verbindung 23 zugleich, d.h. bitparallel, in einen von der Eingabeanordnung 2 umfaßten Schreibspeicher 24 mit einem Ladesignal, das über einen Ladesignaleingang 25 zugeführt wird, geladen. Im Schreibspeicher 24 stehen die Bildpunktdaten zur weiteren Übertragung über den Datenbus 6 zur Verfügung, während unabhängig davon in das Eingangsschieberegister 21 bereits neue Bildpunktdaten über den Eingang 20 eingelesen werden können.

In entsprechender Weise ist die Eingabeanordnung 3 und sind weitere, nicht dargestellte, aber über eine Datenbusfortsetzung 60 (gestrichelte Linien) auf gleiche Weise anschließbare Eingangsanordnungen mit Eingang, z.B. 30, Eingangsschieberegister, z.B. 31, Takteingang, z.B. 32, 28polige Verbindung, z.B. 33, und Schreibspeicher, z.B. 34, aufgebaut.

Um die Kollision von Bildpunktdaten auf dem Datenbus 6 zu vermeiden, erhält jeder der Schreibspeicher 24 bzw. 34 von der Schreibaktivier-Logik 7 über eine Aktivierleitung 26 bzw. 36 ein Aktiviersignal zugeführt. Durch dieses werden die Bildpunktdaten im Schreibspeicher 24 bzw. 34 auf dem Datenbus zur Verfügung gestellt.

Von den 128 parallelen Leitungen des Datenbusses 6 führt im Hauptspeicher 1 jede auf einen von 128 Spaltendecodern 12001 bis 12128, von denen jeder einem der Hauptspeicherblöcke 11001 bis 11128 zugeordnet ist. In jedem der Spaltendecoder 12001 bis 12128 wird die zugehörige Leitung 6001, ... bzw. 6128 des Datenbusses 6 wahlweise mit jeweils einer der Spalten des zugeordneten Hauptspeicherblocks 11001, ... bzw. 11128 zum Übertragen von Bildpunktdaten verbunden. Demgemäß sind die Spaltendecoder 12001 bis 12128 je über eine 64polige Verbindung 13001 bis 13128 mit dem zugehörigen Hauptspeicherblock 11001 bis 11128 gekoppelt.

Das Auswählen einer Spalte eines Hauptspeicherblocks erfolgt durch eine über einen Spaltenadreßeingang 81 zugeführte Spaltenadresse, die im gezeigten Beispiel eine Wortbreite von 6 Bit aufweist und in einem Spaltenadreßspeicher 82 zwischengespeichert wird. Über eine Leitung 83 gelangt die Spaltenadresse auf einen Spaltenadreßdecoder 84, in dem sie eine von 64 Leitungen eines Spaltenadreßbusses 85 mit einem Spaltenauswahlsignal beaufschlagt. Die Spaltendecoder 12001 bis 12128 sind alle parallel an den Spaltenadreßbus 85 angeschlossen, so daß durch eine Spaltenadresse über den Spaltenadreßdecoder 84 in allen Spaltendecodern 12001 bis 12128 die gleiche Spalte des zugehörigen Hauptspeicherblocks 11001 bis 11128 ausgewählt wird. Gleichzeitig über den Datenbus 6 gelieferte Datenbits werden daher in einander entsprechenden Spalten abgespeichert.

Eine 65. Leitung des Spaltenadreßbusses 85 führt von der Schreibaktivier-Logik 7 ebenfalls parallel an alle Spaltendecoder 12001 bis 12128. Auf dieser Leitung 86 wird ein Aktiviersignal ähnlich dem auf den Aktivierleitungen 26 bzw. 36 an die Spaltendecoder 12001 bis 12128 übertragen.

Während für die Spaltenadresse am Spaltenadreßeingang 81 sechs Adreßbits vorgesehen sind, wird die Auswahl der Zeilen der Hauptspeicherblöcke 11001 bis 11128 über eine aus neun Adreßbits bestehende Zeilenadresse vorgenommen, die über einen Zeilenadreßeingang 87 in einen Zeilenadreßspeicher 88 geladen und von diesem über eine Leitung 89 bitparallel einem Zeilenadreßdecoder 90 zugeführt wird. Dieser entspricht in seinem Aufbau dem Spaltenadreßdecoder 84; die einzelnen Zeilen der Hauptspeicherblöcke 11001 bis 11128 werden entsprechend über einen Zeilenadreßbus 91 mit einem Zeilenauswahlsignal einzeln angesteuert. Dazu umfaßt der Zeilenadreßbus 91 im vorliegenden Beispiel 512 parallele Leitungsverbindungen, d.h. 512 parallel laufende Adern. Durch die Zeilenadresse wird zu jedem Zeitpunkt nur über jeweils eine dieser Adern jeweils eine Zeile in jedem der Hauptspeicherblöcke 11101 bis 11128 angesteuert; die Ansteuerung einander entsprechender Zeilen in den einzelnen Hauptspeicherblöcken 11001 bis 11128 erfolgt also gleichzeitig, d.h. parallel zueinander. Demgemäß stehen dann die Datenbits aus diesen Zeilen aller Hauptspeicherblöcke 11001 bis 11128 gleichzeitig an den Spaltendecodern 12001 bis 12128 zur Verfügung und können von diesem zur Weiterleitung über die Leitungen 6001 bis 6128 ausgewählt werden.

Der Hauptspeicher 1, insbesondere die Hauptspeicherblöcke 11001 bis 11128, sind mit dynamischen Speicherzellen aufgebaut, da diese platzsparend und preiswert herzustellen sind. Dynamische Speicherzellen haben jedoch den Nachteil, daß sich ihre Speicherkapazitäten mit der Zeit entladen und daher zur Erhaltung des Ladungszustandes und damit der gespeicherten Datenbits in regelmäßigen Zeitabständen Auffrischvorgänge erforderlich sind. Diese Auffrischvorgänge erfolgen zum einen selbsttätig durch das Adressieren und Lesen einer Zeile eines Hauptspeicherblocks. Gesteuert durch den Zeilenadreßdecoder 90 und über den Zeilenadreßbus 91 werden die Speicherzellen der adressierten Zeile über die Verbindung 13001, ... bzw. 13128 mit Leseverstärkern 14001, ... bzw. 14128 verbunden. Jeder der Leseverstärker 14001 bis 14128 besteht aus 64 Verstärkerzellen, zu jeder Spalte jedes Hauptspeicherblocks 11001 bis 11128 ist eine Verstärkerzelle vorgesehen. Beim Auslesen der Datenbits wird die Ladung auf der adressierten Speicherzelle in der zugehörigen Verstärkerzelle verstärkt und einerseits erneut in derselben Speicherzelle abgespeichert, andererseits über die zugehörige Verbindung 13001 ... bzw. 13128 dem zugehörigen Spaltendecoder 12001, ... bzw. 12128 zugeleitet. Dieser Vorgang wird von einer Verstärker-Zeitsteuerung 92 gesteuert, die über eine Leitung 93 auf alle Leseverstärker 14001 bis 14128 parallel, d.h. gleichzeitig wirkt.

Das Abspeichern der Datenbits in den einzelnen Speicherzellen erfolgt bevorzugt in einer Anordnung, durch die ein hinreichend häufiges Ansprechen jeder Speicherzelle und damit ein rechtzeitiges Auffrischen ermöglicht wird. Insbesondere werden nacheinander eintreffende Datenbits oder zumindest Datenworte in aufeinanderfolgenden Zeilen einer Spalte eines Hauptspeicherblocks abgespeichert. Trotzdem kann der Fall eintreten, daß das Zeitintervall zwischen zwei Lesevorgängen an ein und derselben Speicherzelle zu groß wird. Für diesen Fall enthält die Speicherzellen-Auffrischeinrichtung 9 einen Zeitzähler, der nach Ablauf einer bestimmten Zeitspanne ein vom Datenfluß über den Datenbus 6 unabhängiges Auffrischen der Speicherzellen im Hauptspeicher 1 auslöst. Die Speicherzellen-Auffrischeinrichtung 9 wird dazu über einen Eingang 94 mit einem Auffrischsignal angesteuert. Sie steuert über eine Leitung 95 zum einen den Zeilpnadreßspeicher, durch den für den Auffrischvorgang über den Zeilenadreßdecoder 90 die Hauptspeicherblöcke zeilenweise angesprochen werden; zum anderen wird über eine Leitung 96 die Verstärker-Zeitsteuerung 92 für den Auffrischvorgang initiiert.

Die Schreibaktivier-Logik 7 erhält über Anschlüsse 71, 72, ... Schreibauswahlsignale von außerhalb zugeführt. Durch sie wird diejenige Eingabeanordnung 2, 3, ... ausgewählt, über die dem Hauptspeicher 1 Bildpunktdaten zugeleitet werden sollen. Außerdem werden die Spaltendecoder 12001 bis 12128 über die Leitung 86 mit dem Aktiviersignal beaufschlagt, wenn nur irgendeine Eingabeanordnung 2, 3, ... in Betrieb gesetzt wird.

Die Synchronisation für die Datenweiterleitung in der beschriebenen Speicheranordnung erfolgt durch einen Übernahmetakt, der über einen Takteingang 10 der Schreibaktivier-Logik 7, dem Spalten- und dem Zeilenadreßspeicher 82 bzw. 88 sowie der Verstärker-Zeitsteuerung 92 zugeführt wird.

Zur Ausgabe von Bildpunktdaten über eine oder mehrere der Ausgabeanordnungen 4, 5 (oder weitere über eine Datenbusfortsetzung 61 angeschlossen) werden die Datenworte bitparallel über den Datenbus 6 einem Lesespeicher 40 bzw. 50 zugeleitet und darin zwischengespeichert. Über eine durch eine Schaltereinheit 41 bzw. 51 unterbrechbare, 128polige Verbindung 42 bzw. 52 gelangen die Bildpunktdaten bitparallel auf ein Ausgangsschieberegister 43 bzw. 53, von dem aus die zu jedem Bildpunkt gehörenden Datenworte bitparallel und bildpunktseriell über einen achtpoligen Ausgang 44 bzw. 54 abgegeben werden. Dem Lesespeicher 40 bzw. 50 wird dabei über einen Ladesignaleingang 45 bzw. 55 ein Ladesignal zugeführt, durch das die Übernahme der Bildpunktdaten ausgelöst wird. Über eine gemeinsame Aktivierleitung 46 werden alle Ausgangsschieberegister 43, 53, ... aktiv geschaltet; mit einem Auslesetaktsignal über einen Takteingang 47 bzw. 57 werden die Bildpunktdaten datenwortweise am Ausgang 44 bzw. 54 ausgegeben. Im vorliegenden Beispiel werden somit alle Ausgabeanordnungen 4, 5, ... gemeinsam aktiviert; durch Anlegen des Auslesetaktsignals wird dann aber bestimmt, in welcher Weise aus welcher Ausgabeanordnung Bildpunktdaten entnommen werden.

Über einen Rücksetzeingang 48 bzw. 58 wird der Ausgabeanordnung 4 bzw. 5 ein Rücksetzsignal zugeführt. Dadurch wird zum einen der gesamte Inhalt des Ausgangsschieberegisters 43 bzw. 53 auf "0" gesetzt und zum anderen über die Schaltereinheit 41 bzw. 51 die Verbindung 42 bzw. 52 aufgetrennt. Über das Rücksetzsignal ist es somit auch möglich, einzelne Ausgänge 44 bzw. 54 abzuschalten, um nur von einigen Ausgängen Bildpunktdaten zu entnehmen.

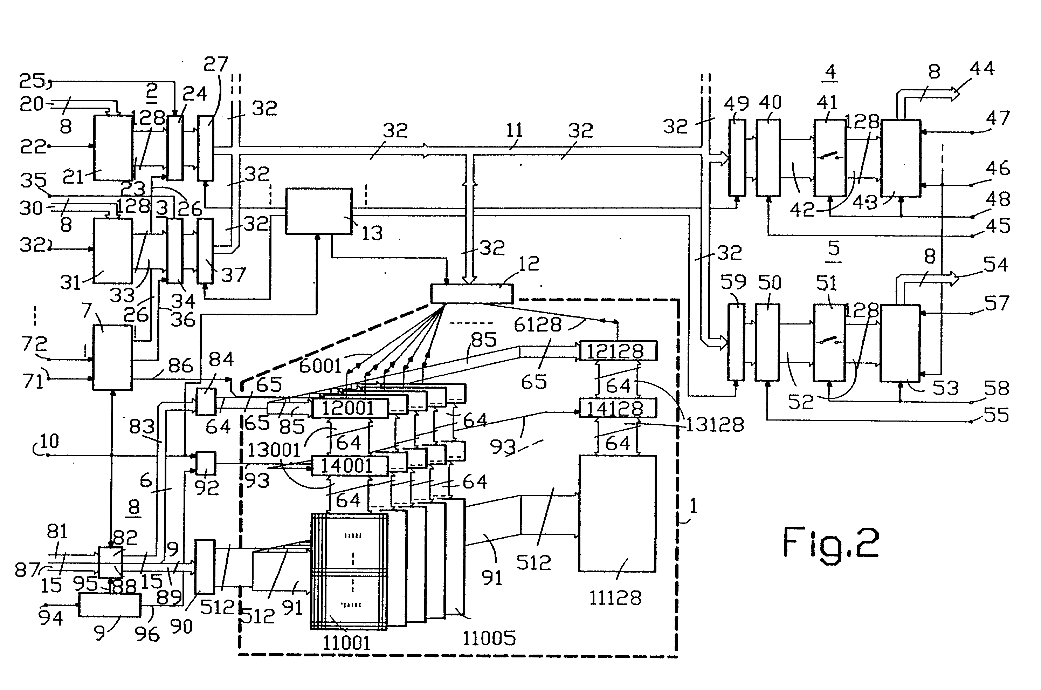

Die Speicheranordnung im Ausführungsbeispiel nach Fig. 2 entspricht weitgehend der Anordnung nach Fig. 1; mit dortigen Baugruppen übereinstimmende Teile sind wieder mit identischen Bezugszeichen versehen. Bei der Anordnung nach Fig. 2 ist der 128polige Datenbus 6 durch einen Datenbus 11 mit nur 32 parallel laufenden Leitungen ersetzt. Der Übergang von den 128poligen Verbindungen 23 bzw. 33 erfolgt in Multiplexanordnungen 27 bzw. 37, in denen jeweils ein zeitlicher Vierfach-Multiplex vorgenommen wird, d.h. eine teilweise Rückwandlung in einen seriellen Übertragungsmodus. In diesem werden dann jeweils vier Datenworte zu je acht Datenbits bitparallel auf dem Datenbus 11 übertragen. Entsprechend sind bei den Ausgabeanordnungen 4, 5 Demultiplexanordnungen 49 bzw. 59 vorgesehen, in denen die über den Datenbus 11 eintreffenden Bildpunktdaten im Vierfach-Demultiplex auf die 128 Speicherplätze der Lesespeicher 40 bzw. 50 verteilt werden.

Der Hauptspeicher 1 ist im Beispiel nach Fig. 2 mit seinen Leitungen 6001 bis 6128 an eine kombinierte Multiplex-Demultiplex-Anordnung 12 angeschlossen, über die einen entsprechende Verteilung der Bildpunktdaten vom Datenbus 11 auf die Spaltendecoder 12001 bis 12128 und umgekehrt von den Spaltendecodern 12001 bis 12128 auf den Datenbus 11 erfolgt.

Sämtliche Multiplexanordnungen 27, 37, ..., Demultiplexanordnungen 49, 59, ... sowie die Multiplex-Demultiplex-Anordnung 12 werden über eine gemeinsame Datenbussteuerung 13 gesteuert, die durch den Übernahmetakt vom Takteingang 10 synchronisiert wird. Da die Datenbussteuerung lediglich dafür zu sorgen hat, daß zum gleichen Zeitpunkt am Datenbus 11 einander entsprechende Leitungen von den Schreibspeichern 24 bzw. 34, den Lesespeichern 40 bzw. 50 und den Spaltendecodern 12001 bis 12128 miteinander verbunden sind, braucht sie lediglich eine synchronisierte Fortschaltung der genannten Anordnungen vorzunehmen. Dabei ist eine genaue Fortschaltfrequenz nicht erforderlich; sie sollte jedoch mindestens das Vierfache der Übertragungsfrequenz, d.h. der Folgefrequenz der Datenbits auf dem Datenbus 6 gemäß Fig. 1 betragen. Durch die Verringerung der Leitungsverbindungen des Datenbusses 11 kann bei einer Mehrzahl von Ein- und Ausgabeanordnungen der Aufbau der Speicheranordnung vereinfacht werden.

Anzahl und Größe der Blöcke, Spalten und Zeilen des Hauptspeichers 1 in den vorstehend beschriebenen Beispielen können unter entsprechender Anpassung der Zeilen- und Spaltendecoder sowie der Adressierung leicht den jeweiligen Gegebenheiten angepaßt werden, ohne dadurch den prinzipiellen Aufbau zu verändern. Damit ist eine Anpassung an verschiedene Aufgaben der Speicheranordnung, beispielsweise an verschiedene Fernsehnormen, leicht möglich. Der beschriebene Aufbau ermöglicht außerdem die Verwendung von Speicherzellen mit geringerer Arbeitsgeschwindigkeit, ohne daß diese zu einer Begrenzung der Übertragungsgeschwindigkeit der Speicheranordnung führt.

Bei den Beispielen nach Fig. 1 und 2 ist die Reihenfolge des Ein- und Auslesens der Bildpunktdaten aus dem Haupt speicher aufgrund der Spalten- und Zeilenadressierung in beliebiger Reihenfolge möglich. Für spezielle Einsatzzwecke kann es ausreichen, Spalten und Zeilen des Hauptspeichers 1 in vorgegebener Reihenfolge anzusprechen. Anstelle der Spalten- und Zeilenadreßspeicher 82, 88 können dann einfache Zählerschaltungen treten, die von außen getaktet und synchronisiert werden. Dadurch können Anschlüsse an der Speicheranordnungen eingespart werden.

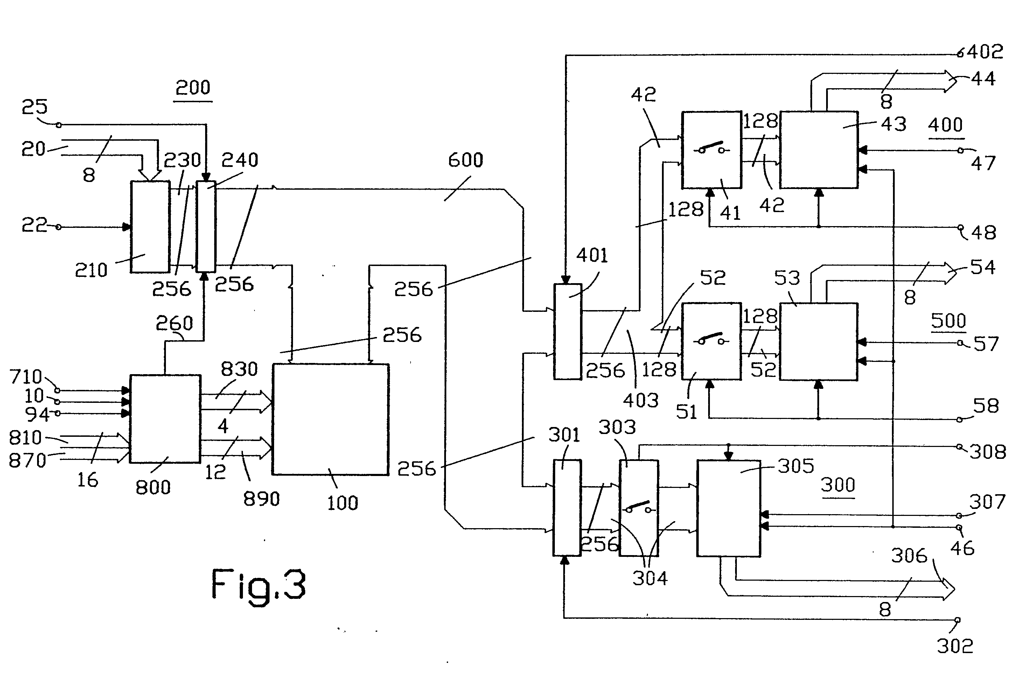

Fig. 3 zeigt in vereinfachter, blockschematischer Darstellung ein weiteres Ausführungsbeispiel einer erfindungsgemäßen Speicheranordnung mit einem Hauptspeicher 100, einer Eingabeanordnung 200 sowie dreier Ausgabeanordnungen 300, 400, 500. Der Hauptspeicher 100 entspricht weitgehend dem Hauptspeicher 1 nach Fig. 1 und 2, er weist jedoch eine andere Einteilung der Blöcke, Zeilen und Spalten auf. Die Bildpunktdaten werden über einen Datenbus 600 mit 256 parallel laufenden Leitungen zu- bzw. abgeführt; entsprechend weist der Hauptspeicher 100 eine Anzahl von 256 Hauptspeicherblöcken auf. Gemäß der geänderten Spalten- und Zeilenaufteilung des Hauptspeichers 100 umfassen der Spaltenadreßeingang 810 und die Leitung 830 zum übertragen der Spaltenadresse an den Hauptspeicher 100 eine Anzahl von vier parallelen Leitungen, während der Zeilenadreßeingang 870 und die Leitung 890 zum Übertragen der Zeilenadresse entsprechend den 12 Zeilenadreßbits 12 parallele Leitungen enthält. Adreßspeicher und -decoder sind der vereinfachten Darstellung wegen in Fig. 3 zu einer gemeinsamen Baugruppe, der Speichersteuerung 800, zusammengefaßt. Entsprechend Fig. 1 und 2 sind außerdem eine Aktivierleitung 260 für ein Aktiviersignal an den Schreibspeicher 240 sowie ein Anschluß 710 für ein von außen zuführbares Schreibauswahlsignal, der Takteingang 10 für den Übernahmetakt sowie der Eingang 94 für das Auffrischsignal vorgesehen.

Die Eingabeanordnung 200 weist entsprechend Fig. 1 und 2 ein - jetzt auf ein Format von 32 Datenworten zu je acht Bit verändertes - Eingangsschieberegister 210 auf, das die Bildpunktdaten bitparallel über eine 256polige Verbindung 230 dem Schreibspeicher 240 zuleitet. Das Eingangsschieberegister 210 ist wieder mit dem achtpoligen Eingang 20 und dem Takteingang 22, der Schreibspeicher 240 mit dem Ladesignaleingang 25 verbunden.

Die erste Ausgabeanordnung 300 entspricht in ihrem Aufbau den Ausgabeanordnungen 4, 5 gemäß Fig. 1 und 2 mit einer Anpassung an das geänderte Datenformat. Entsprechend ist der Datenbus 600 an einen Lesespeicher 301 mit 256 parallelen Speicherzellen angeschlossen, dem ein Ladesignal über einen Ladesignaleingang 302 zugeleitet wird. Über eine durch eine Schaltereinheit 303 unterbrechbare 256polige Verbindung 304 werden die im Lesespeicher 301 gespeicherten Datenbits parallel auf ein Ausgangsschieberegister 305 gegeben. Von dort werden die Bildpunktdaten über einen achtpoligen Ausgang 306 bildpunktseriell und innerhalb des einzelnen, durch ein Datenwort dargestellten Bildpunktes bitparallel abgegeben. Daher weist das Ausgangsschieberegister 305 ein Format von 32x8 Speicherplätzen auf. Gemäß der Ausgabeanordnung 4 ist weiterhin eine Verbindung mit der Aktivierleitung 46, ein Takteingang 307 für ein Auslesetaktsignal entsprechend dem Takteingang 47 sowie ein Rücksetzeingang 308 für ein Rücksetzsignal entsprechend dem Rücksetzeingang 48 aus der Ausgabeanordnung 4 nach Fig. 1 oder 2 vorgesehen.

Die Ausgabeanordnungen 400 und 500 werden über einen gemeinsamen Lesespeicher 401 mit Bildpunktdaten versorgt. Der Lesespeicher 401 umfaßt 256 parallele Speicherzellen entsprechend 256 parallelen Leitungen des Datenbusses 600. Er wird über einen gemeinsamen Ladesignal eingang 402 mit einem gemeinsamen Ladesignal gesteuert. Hinter dem Lesespeicher 401 werden die 256 parallel laufenden Leitungen einer Verbindung 403 auf zwei 128polige Verbindungen 42 und 52 aufgeteilt, die den mit den gleichen Bezugszeichen versehenen Verbindungen der Ausgabeanordnungen 4, 5 aus Fig. 1 und 2 baugleich sind. Diese Verbindungen 42, 52 führen über die Schaltereinheiten 41, 51 auf die Ausgangsschieberegister 43, 53; diese Teile der Ausgabeanordnungen 400 bzw. 500 nebst ihrer Ansteuerung stimmen exakt mit den entsprechenden Teilen der Ausgabeanordnungen 4 bzw. 5 überein und sind daher ebenfalls mit identischen Bezugszeichen versehen.

Die Ausgabeanordnungen 400 und 500 können über die Takteingänge 47 bzw. 57 mit der gleichen Datenausgabefrequenz an den Ausgängen 44 bzw. 54 betrieben werden wie der Ausgang 306 der Ausgabeanordnung 300. Durch einen außerhalb der beschriebenen Speicheranordnung mit den Ausgängen 44 und 54 verbundenen, schnellen Multiplexer können die Datenströme über diese Ausgänge zu einem einzigen Datenausgang gleicher Datenwortbreite, jedoch verdoppelter Übertragungsgeschwindigkeit vereinigt werden. Unter der Annahme, daß sowohl die Ausgänge 44, 54 als auch der Ausgang 306 mit der höchstmöglichen, durch die Fertigungsart und den Aufbau der Speicheranordnung bestimmten Übertragungsgeschwindigkeit betrieben werden, kann so bei entsprechender Aufteilung der Datenströme vom gemeinsamen Lesespeicher 401 auf die Ausgabeanordnungen 400 und 500 ein Datenstrom doppelter Übertragungsgeschwindigkeit aus der Speicheranordnung entnommen werden.

Unterschiedlichen Übertragungsgeschwindigkeiten an den Ausgängen der einzelnen Ausgabeanordnungen kann im übrigen dadurch Rechnung getragen werden, daß diesen aus dem Hauptspeicher Bildpunktdaten mit unterschiedlicher Übertragungsrate zugeführt werden; beispielsweise werden in den Lesespeicher einer Ausgabeanordnung innerhalb eines Zeitintervalls zweimal Bildpunktdaten aus dem Hauptspeicher eingelesen, wohingegen dem Lesespeicher in diesem Zeitintervall nur ein Satz Bildpunktdaten zugeleitet wird. Umgekehrt können die Lesespeicher gleichmäßig mit Bildpunktdaten versorgt werden, diese können jedoch aus den Ausgangsschieberegistern ein- oder mehrmals über die Ausgänge abgegeben werden, bevor in die Lesespeicher und anschließend in die Ausgangsschieberegister neue Bildpunktdaten übernommen werden.

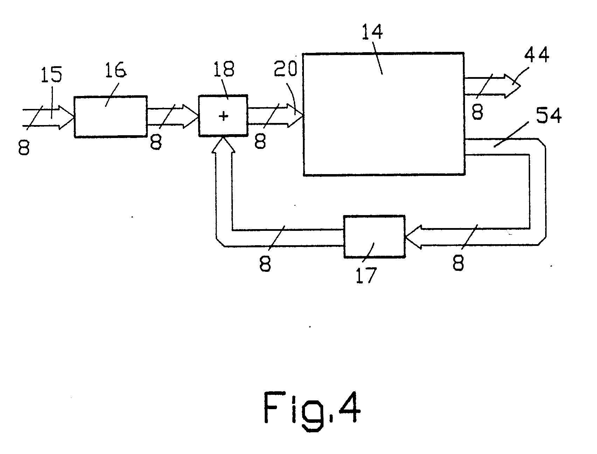

Fig. 4 zeigt ein einfaches Ausführungsbeispiel für die Anwendung einer erfindungsgemäßen Speicheranordnung. Diese ist in Fig. 4 mit dem Bezugszeichen 14 versehen und umfaßt beispielsweise eine Anordnung gemäß Fig. 1 mit einer Eingabeanordnung 2, zwei Ausgabeanordnungen 4, 5, einem Hauptspeicher 1, einer Speichersteuerung (z.B. 7, 8, 9) sowie dem Datenbus 6. In der vereinfachten Darstellung der Fig. 4 sind lediglich der Eingang 20 sowie die Ausgänge 44, 54 wiedergegeben.

Die Speicheranordnung 14 ist im Ausführungsbeispiel nach Fig. 4 als Teilbildspeicherbaustein in einem rekursiven Filter eingesetzt. Diesem Filter wird über einen Bilddateneingang 15 eine Folge von Bildpunktdaten bitparallel und bildpunktseriell zugeführt. In einer digitalen Stellstufe 16 werden die Bildpunktdaten vom Bilddateneingang 15 um einen Faktor zwischen 0 und 1 vermindert, d.h. mit der Differenz aus der Zahl 1 und diesem Faktor multipliziert. Über einen Addierer 18 gelangen die Bildpunktdaten dann an den Eingang 20 der Speicheranordnung 14.

Vom Ausgang 54 werden die Bildpunktdaten aus der Speicheranordnung 14 mit der gleichen Übertragungsrate abgegeben, wie sie auch am Eingang 20 vorhanden ist. Über eine (zweite) digitale Stellstufe 17, in der diese Bildpunktdaten mit dem genannten Faktor im Wertebereich zwischen 0 und 1 multipliziert werden, gelangen die so veränderten Datenworte an einen zweiten Eingang des Addierers 18, wo sie den Bildpunktdaten vom Bilddateneingang 15 bzw. von der (ersten) digitalen Stellstufe 16 additiv überlagert werden.

Der Ausgang 44 der Speicheranordnung 14 wird mit einer gegenüber dem Eingang 20 und dem Ausgang 54 doppelten Übertragungsrate betrieben. Beispielsweise ist an den Ausgang 44 eine Bildwiedergabeanordnung zur flimmerfreien Bildwiedergabe angeschlossen.

Die erfindungsgemäße Speicheranordnung läßt sich als Bild-oder Teilbildspeicher unterschiedlicher Größe aufbauen. Es können Leuchtdichte- und Farbsignale in einer einzigen Speicheranordnung in verschiedenen Datenformaten abgespeichert werden. Eine einfache Kombination mehrerer der beschriebenen Speicheranordnungen ist ebenfalls leicht möglich. Die Speicherkonfiguration kann beliebig den Bildformaten und Übertragungsraten angepaßt werden. Dies ist insbesondere durch eine entsprechende Wahl der Speichergröße der Eingangs- und Ausgangsschieberegister, insbesondere der Anzahl der von ihnen zu speichernden Datenworte, einfach möglich. Die erfindungsgemäßen Speicheranordnungen sind einfach und preiswert aufgebaut und daher besonders für den Einsatz im Konsumgüterbereich geeignet.

## Ansprüche

1. Speicheranordnung (14) zum Abspeichern der Bildpunktdaten eines Fernsehbildes
- mit einem block- und darin spalten- und zeilenweise gegliederten Hauptspeicher (1),
- einem Spaltendecoder (12001, ...) zu jedem Hauptspeicherblock (11001, ...) zum Auswählen einer Spalte des Hauptspeichers (1) gemäß einer von außerhalb zuführbaren Spaltenadresse (an 81),
- einem für alle Hauptspeicherblöcke (11001, ...) wirksamen Zeilendecoder (90) zum gemeinsamen Auswählen einer Zeile in jeder Spalte jedes Hauptspeicherblocks (11001, ...) gemäß einer von außerhalb zuführbaren Zeilenadresse (an 87),
- wenigstens einer Eingabeanordnung (2) aus einem Eingangsschieberegister (21) zum bildpunktseriellen Einlesen abzuspeichernder Bildpunktdaten (an 20) und einem Schreibspeicher (24) zur bildparallelen Übergabe der Bildpunktdaten vom Eingangsschieberegister (21) zu je Datenbit einem der Hauptspeicherblöcke (11001, ...) - und wenigstens zwei Ausgabeanordnungen (4, 5) aus je einem Ausgangsschieberegister (43, 53) zum bildpunktseriellen Auslesen auszugebender Bildpunktdaten (an 44, 54) und einem Lesespeicher (40, 50) zur bitparallelen Übergabe der Bildpunktdaten von je Datenbit einem der Hauptspeicherblöcke (11001, ...) zum Ausgangsschieberegister (43, 53).

2. Speicheranordnung nach Anspruch 1, dadurch gekennzeichnet, daß jede der Ein- und Ausgabeanordnungen (2, 3 bzw. 4, 5) mit unterschiedlicher Datenfrequenz und/oder in unterschiedlicher Folge der Datenein- und -ausgabe betreibbar ist.

3. Speicheranordnung nach Anspruch 1 oder 2, dadurch gekennzeichnet, daß der Hauptspeicher (1) mit dynamischen Speicherzellen aufgebaut und der Zeilendecoder (90) mit einer Speicherzellen-Auffrischeinrichtung (9) gekoppelt ist.

4. Speicheranordnung nach Anspruch 1, 2 oder 3, dadurch gekennzeichnet, daß Haupt- (1), Schreib- (24, 34) und Lesespeicher (40, 50) über einen gemeinsamen Datenbus (6 bzw. 11) miteinander verbunden sind.

5. Speicheranordnung nach Anspruch 4, dadurch gekennzeichnet, daß die Bildpunktdaten auf dem Datenbus (11) im Multiplex übertragbar sind.

Fig.1

EP 0 386 841 A2

1-IV-PHD 89-040

Fig.2

EP 0 386 841 A2

2-IV-PHD 89-040

Fig.3

Fig.4